Europäisches Patentamt

European Patent Office

Office européen des brevets

(19)

(11) Numéro de publication: **0 101 120**
**B1**

(12) **FASCICULE DE BREVET EUROPEEN**

(45) Date de publication du fascicule du brevet: **20.11.86**

(51) Int. Cl.⁴: **H 01 L 29/08, H 01 L 29/28**

(21) Numéro de dépôt: **83201111.8**

(22) Date de dépôt: **28.07.83**

(54) **Dispositif semi-conducteur comportant un transistor à effet de champ composé de plusieurs transistors partiels montés en parallèle.**

(30) Priorité: **09.08.82 FR 8213861**

(43) Date de publication de la demande:
**22.02.84 Bulletin 84/08**

(45) Mention de la délivrance du brevet:
**20.11.86 Bulletin 86/47**

(84) Etats contractants désignés:
**DE FR GB NL**

(56) Documents cités:
**EP-A-0 050 773**

(73) Titulaire: **RTC-COMPELEC**
**130, Avenue Ledru-Rollin**
**F-75011 Paris (FR)**
(84) **FR**

(73) Titulaire: **N.V. Philips' Gloeilampenfabrieken**
**Groenewoudseweg 1**
**NL-5621 BA Eindhoven (NL)**
(84) **DE GB NL**

(72) Inventeur: **David, Gérard Robert**
**Société Civile S.P.I.D. 209 rue de l'Université**
**F-75007 Paris (FR)**

(74) Mandataire: **Pinchon, Pierre et al**
**Société Civile S.P.I.D. 209 rue de l'Université**
**F-75007 Paris (FR)**

Courier Press, Leamington Spa, England.

## Description

L'invention concerne un dispositif semiconducteur comportant un corps semiconducteur d'un premier type de conduction, muni d'une surface plane et dans lequel est inséré un transistor à effet de champ à électrode de porte isolée composé de plusieurs transistors partiels montés en parallèle comprenant chacun une cellule en forme de boîte polygonale, cellules qui comprennent une première zone semiconductrice d'un second type de conduction opposé au premier, munie d'un bord perpendiculaire à la surface s'étendant de façon qu'une partie périphérique du corps semiconducteur entourant la première zone affleure la surface, première zone dans laquelle est noyée une seconde zone du premier type de conduction affleurant la surface et munie d'une ouverture centrale et d'un bord s'étendant à une distance pratiquement constante du bord de la première zone de façon qu'une partie centrale et une bande marginale étroite de la première zone affleurent la surface, la jonction pn formée par la partie centrale de la première zone et la seconde zone étant court-circuitée par une métallisation appliquée sur la surface, la bande marginale s'étendant sur au moins une partie de sa longueur, à une distance pratiquement constante de parties correspondantes de bandes marginales de cellules voisines.

La partie périphérique du corps semiconducteur entourant la première zone sert de zone de drain du transistor partiel, alors que la seconde zone affleurant la surface sert de zone de source du transistor partiel. La bande marginale étroite de la première zone située entre la zone de drain et la zone de source sert de zone de canal du transistor partiel. La jonction pn formée par la partie centrale de la première zone est court-circuitée par une métallisation appliquée sur la surface.

Un tel dispositif semiconducteur est destiné à des circuits de moyenne ou grande puissance et peut être commandé de façon directe à partir de circuits intégrés.

De la demande de brevet britannique n° 2.033.658 est connu un dispositif semiconducteur du genre mentionné dans le préambule, dans lequel les transistors partiels montés en parallèle comprennent chacun une cellule hexagonale. La bande marginale étroite de la première zone constituant la zone de canal du transistor partiel, s'étend à une distance constante du bord de la cellule et présente donc également une forme hexagonale.

Dans le cas de tensions relativement faibles entre la zone de source et la zone de drain, un tel transistor se comporte comme une résistance. La grandeur de cette résistance est tributaire de la longueur du périmètre de la bande marginale servant de canal et de la superficie de la partie périphérique du corps semiconducteur entourant la première zone. Cette superficie est pratiquement égale au produit de la longueur 1 de la bande marginale étroite de la première zone par la moitié de la distance d entre les bandes marginales s'étendant à une distance pratiquement constante l'une de l'autre des cellules voisines. Il importe que ladite résistance soit aussi faible que possible. De ce fait, la superficie de la région périphérique doit former une partie aussi grade que possible de la surface totale S de la cellule. Pour une distance d qui ne peut pas être choisie librement—elle est tributaire entre autres des tolérances de photogravure à observer pendant la réalisation du dispositif semiconducteur—, il faut que le rapport 1/S soit aussi élevé que possible. Dans le cas d'une cellule hexagonale, comme celle du dispositif semiconducteur citée ci-dessus, il s'avère que le rapport 1/S est au maximum de $d^{-1}$, cas qui se présente lorsque $1 = 2 \cdot d \cdot \sqrt{3}$ et $S = 2 \cdot d^2 \cdot \sqrt{3}$. Le rapport 1/S est dit facteur de remplissage et s'avère être également au maximum de $d^{-1}$ pour les cellules carrées et triangulaires.

Dans le transistor connu, une partie centrale de la première zone affleure la surface du corps semiconducteur. Cela implique que, pour des raisons techniques de fabrication, 1 et S soident respectivement d'environ $10 \cdot d$ et $15 \cdot d^2$ dans le cas où $d = 8$ μm. Le facteur de remplissage qui devrait être de 125 mm/mm2 est inférieur d'environ 30% pour les susdites raisons.

L'un des buts de l'invention est d'obtenir un dispositif semiconducteur du genre mentionné dans le préambule dans lequel ledit facteur de remplissage 1/S se rapproche plus de la valeur théorique.

Conformément à l'invention, le dispositif du genre mentionné dans le préambule est caractérisé en ce que la bande marginale présente des méandres définissant des portions en forme de bande de la partie périphérique, portions qui s'étendent dans la direction de la partie centrale de la première zone.

La disposition conforme à l'invention permet d'atteindre un facteur de remplissage d'envrion 120 mm/mm2 dans le cas où $d = 8$ μm. De préférence, un dispositif semiconducteur conforme à l'invention est caractérisé en ce que les portions en forme de bande s'étendant dans la direction de la partie centrale de la première zone présentent une largeur pratiquement égale à la distance séparant les bandes marginales de cellules voisines.

On évite ainsi la formation de grandes variations en densité de courant dans la partie du corps semiconducteur entourant la première zone.

La description ci-après, en se référant aux dessins annexés, le tout donné à titre d'exemple non limitatif, fera bien comprendre comment l'invention peut être réalisée.

La figure 1 montre schématiquement une vue en plan d'un dispositif semiconducteur conforme à l'invention.

La figure 2 montre en coupe le même dispositif semiconducteur selon la ligne II—II de la figure 1.

La figure 3 représente en coupe le dispositif semiconducteur selon la ligne III—III de la figure 1.

La figure 4 représente une vue en plan d'une variante du dispositif semiconducteur conforme à l'invention.

La figure 5 montre une vue en plan d'une autre variante dudit dispositif selon l'invention.

Les figures sont représentées schématiquement et non à l'échelle. Pour la clarté des dessins, les couches isolantes et les couches de contact électroconductrices sont omises sur les vues en plan.

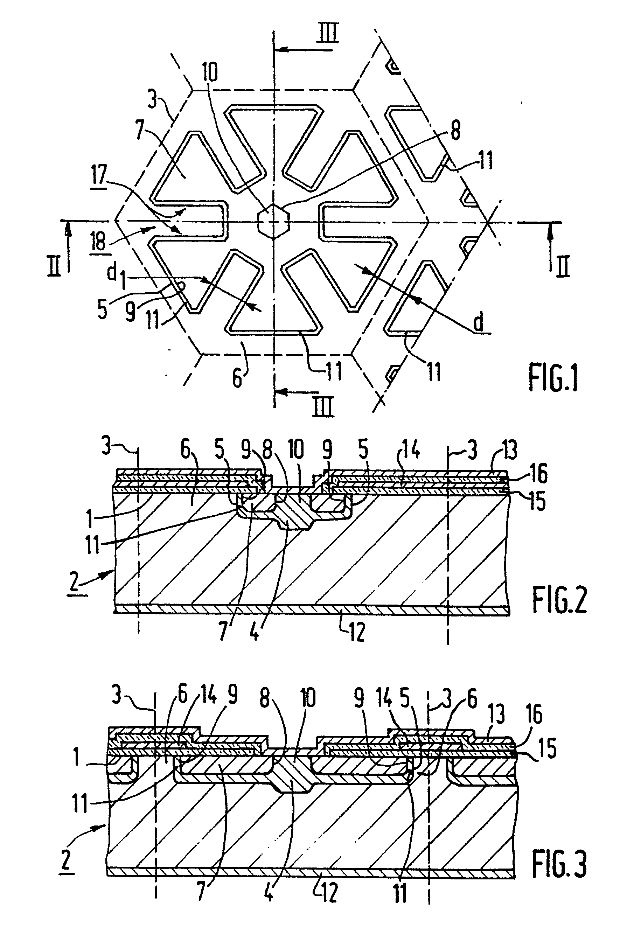

Les figures 1, 2 et 3 montrent un dispositif semiconducteur présentant un corps semiconducteur 2 d'un premier type de conduction muni d'une surface plane 1, de type de conduction $n$ dans cet exemple, dans lequel est inséré un transistor à effet de champ composé de plusieurs transistors partiels montés en parallèle et comprenant chacun une cellule 3 en forme de boîte. Chaque cellule 3 comprend une première zone semiconductrice 4 du second type de conduction opposé au premier, dans ce cas le type de conduction p, zone 4 qui est munie d'un bord 5 perpendiculaire à la surface 1 et s'étendant de façon qu'une partie périphérique 6 du corps semiconducteur 2 entourant la première zone 4, affleure la surface 1. Dans la première zone 4, est noyée une seconde zone 7 du premier type de conduction, dans ce cas le type de conduction n, qui affleure la surface 1 et qui est munie d'une ouverture centrale 8 et d'un bord 9 s'étendant à une distance pratiquement constante du bord 5 de la première zone 4. Ainsi, une partie centrale 10 et une bande marginale étroite 11 de la première zone 4 affleurent la surface 1.

La partie périphérique 6 sert de zone de drain du transistor partiel sur laquelle un contact est pris à l'aide d'une métallisation 12 appliquée sur la face arrière du corps semiconducteur 2. La seconde zone 7 affleurant la surface 1 sert de zone de source du transistor partiel et est recouverte d'une métallisation 13 servant de prise de contact. La bande marginale étroite 11 sert de zone de canal du transistor partiel au-dessus de laquelle se trouve une électrode de porte 14 réalisée en silicium polycrystallin et séparée de la surface 1 par une couche isolante en oxyde de silicium 15 et de la métallisation 13 par une couche isolante en oxyde de silicium 16. La jonction pn comprise entre la partie centrale 10 de la zone 4 et la seconde zone 7 est court-circuitée par la métallisation 13.

Dans le cas d'un fonctionnement à des tensions relativement faibles se produisant entre drain et source, le transistor se comporte comme une résistance dont la grandeur est tributaire de la longueur du périmètre de la bande marginale 11 servant de canal. Il importe que cette résistance soit aussi faible que possible et que, de ce fait, ledit périmètre soit aussi grand que possible.

La bande marginale 11 s'étend sur une partie de sa longueur à une distance pratiquement constante $d$ de parties correspondantes de bandes marginales de cellules voisines.

Conformément à l'invention, et vue de dessus, la bande marginale 11 présente des méandres 17 qui définissent des portions en forme de bande 18 de la partie périphérique 6, portions 18 qui s'étendent dans la direction de la partie centrale 10 de la première zone 4.

De préférence, les portions en forme de bande 18 présentent une largeur $d_1$ qui est pratiquement égale à la distance d séparant les bandes marginales 11 de cellules voisines. On évite ainsi la formation de grandes variations en densité de courant dans la partie du corps semiconducteur 2 entourant la première zone 4.

Afin d'assurer que la résistance du transistor à l'état passant ($R_{on}$) soit aussi faible que possible, il faut que le périmètre de la bande marginale 11 soit aussi grand que possible pour une surface totale S donnée de cellule. La distance d ne pouvant pus être choisie librement—elle est tributaire entre autres des tolérances de photogravure à observer pendant la réalisation du dispositif semiconducteur—, il faut faire en sorte que le rapport entre la longueur 1 de la bande marginale 11 et la surface S soit aussi élevé que possible. Il s'avère que le rapport 1/S est au maximum égal à $d^{-1}$. Du fait que pour des raisons techniques, il faut une certaine distance entre la partie centrale 10 de la première zone 4 et la bande marginale 11, la valeur maximale 1/S n'est pas atteinte en pratique bien qu'on s'en rapproche de très près. Lorsque d=8 μm, 1/S devrait être de 125 mm/mm2; toutefois, en pratique, cette valeur est de 120 mm/mm2 du fait que, dans ce cas, 1 et S ne peuvent être fixés aux valeurs optimales mentionnées ci-dessus.

Il y a lieu de noter que la distance comprise entre la partie centrale 10 de la zone 4 et la bande marginale 11 varie entre environ 7 et 25 μm. Cependant, contrairement au principe admis et appliqué actuellement sur les dispositifs connus qui consiste à maintenir constante cette distance de manière à garantir une tenue en inverse correcte notamment au second claquage, la Demanderesse a constaté que dans le cas de dispositifs fonctionnant à basse ou moyenne tension, c'est-à-dire à moins de 200 volts, les variations de cette distance n'influent pas sur la caractéristique de tenue en tension.

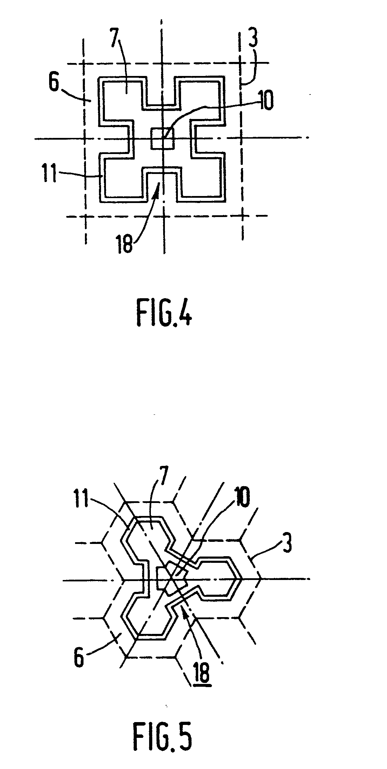

Les figures 4 et 5 montrent schématiquement une vue de dessus de variantes du dispositif semiconducteur conforme à l'invention. Sur ces figures, les éléments assurant les mêmes fonctions mais, le cas échéant, ayant une forme différente sont désignés par les mêmes chiffres de référence que sur la figure 1. Sur la figure 4, la cellule 3 présente une forme carrée, tandis que sur la figure 5, elle présente une forme composée de trois motifs élémentaires sensiblement hexagonaux.

Dans tous les exemples, on constate que les cellules 3 sont réalisées à partir de motifs élémentaires juxtaposés.

Dans l'exemple de la figure 1, les cellules comportent six motifs élémentaires de forme triangulaire; dans l'exemple illustré par la figure 4, quatre motifs élémentaires sensiblement carrés et, dans l'exemple de la figure 5, trois motifs élémentaires sensiblement hexagonaux.

**Revendications**

1. Dispositif semiconducteur comportant un corps semiconducteur (2) d'un premier type de conduction muni d'une surface plane et dans lequel est inséré un transistor à effet de champ à électrode de porte isolée composé de plusieurs transistors partiels montés en parallèle comprenant chacun une cellule (3) en forme de boîte polygonale, cellules qui comprennent une première zone semiconductrice (4) d'un second type de conduction opposé au premier, munie d'un bord (5) perpendiculaire à la surface s'étendant de façon qu'une partie périphérique (6) du corps semiconducteur entourant la première zone affleure la surface, première zone dans laquelle est noyée une seconde zone (7) du premier type de conduction affleurant la surface et munie d'une ouverture centrale (8) et d'un bord (9) s'étendant à une distance pratiquement constante du bord (5) de la première zone de façon qu'une partie centrale (10) et une bande marginale étroite (11) de la première zone affleurent la surface, la jonction pn formée par la partie centrale (10) de la première zone (4) et la second zone (7) étant court-circuitée par une métallisation (13) appliquée sur la surface, la bande marginale (11) s'étendant sur au moins une partie de sa longueur, à une distance (d) pratiquement constante de parties correspondantes de bandes marginales de cellules voisines, caractérisé en ce que la bande marginale (11) présente des méandres (17) définissant des portions en forme de bande (18) de la partie périphérique (6), portions qui s'étendent dans la direction de la partie centrale (10) de la première zone (4).

2. Dispositif semiconducteur selon la revendication 1, caractérisé en ce que les portions en forme de bande (18) s'étendant dans la direction de la partie centrale (10) de la première zone (4) présentent une largeur (dl) pratiquement égale à la distance (d) séparant les bandes marginales de cellules voisines.

3. Dispositif semiconducteur selon l'une des revendications 1 et 2, caractérisé en ce que la cellule (3) présente la forme d'un hexagone.

4. Dispositif semiconducteur selon l'une des revendications 1 et 2, caractérisé en ce que la cellule (3) présente la forme d'un carré.

5. Dispositif semiconducteur selon l'une des revendications 1 et 2, caractérisé en ce que la cellule (3) est un ensemble de trois motifs élémentaires hexagonaux.

**Patentansprüche**

1. Halbleiteranordnung mit einem Halbleiterkörper (2) eines ersten Leitungstyps mit einer planaren Ebene und in der eine Feldeffekttransistor mit einer isolierten Gate-Elektrode gebildet ist, der aus einer Anzahl parallelgeschalteter Teiltransistoren zusammengestellt ist, wobei die Teiltransistoren je eine polygonale dosenförmige Zelle (3) aufweisen, wobei die Zellen je eine erste Halbleiterzone (4) von zweiten, dem ersten entgegengesetzten Leitungstyp aufweisen, mit einem Rand (5) senkrecht zu der Oberfläche und sich dabei derart erstreckend, dass ein Randteil (6) des Halbleiterkörper, der die erste Zone umgibt, die Oberfläche berührt, wobei in diese erste Zone eine zweite Zone (7) vom ersten Leitungstype eingebettet ist, welche die Oberfläche berührt und mit einer zentralen Öffnung (8) sowie einem Rand (9) versehen ist, der sich in einem nahezu konstanten Abstand von dem Rand (5) der ersten Zone erstreckt und zwar derart, dass ein zentraler Teil (10) und ein schmaller Randstreifen (11) der ersten Zone die Oberfläche berührt, wobei der pn-Übergang, der durch den zentralen Teil (10) der ersten Zone (4) und der zweiten Zone (7) gebildet wird, durcheine Metallisierung (13), die auf der Oberfläche angebracht ist, kurzgeschlossen ist, wobei der Randstreifen (11) sich über mindestens einen Teil der Länge in einem nahezu konstanten Abstand (d) von den entsprechenden Teilen der Randstreifen der Nachbarzellen erstreckt, dadurch gekennzeichnet, dass der Randstriefen (11) Meander (17) aufweist, die Teile in Form des Streifens (18) des Randteils (6) definieren, die sich in Richtung des zentralen Teils (10) der ersten Zone (4) erstrecken.

2. Halbleiteranordnung nach Anspruch 1, dadurch gekennzeichnet, dass die streifenförmigen Teile (18), die sich in Richtung des zentralen Teils (10) der ersten Zone (4) erstrecken, eine Breite (dl) aufweisen, die dem Abstand (d) zwischen den Randstreifen der Nachbarzelle nahezu entspricht.

3. Halbleiteranordnung nach einem der Ansprüche 1 und 2, dadurch gekennzeichnet, dass die Zelle (3) die Form eines Hexagons hat.

4. Halbleiteranordnung nach einem der Ansprüche 1 und 2, dadurch gekennzeichnet, dass die Zelle (3) die Form eines Vierecks hat.

5. Halbleiteranordnung ach einem der Ansprüche 1 und 2, dadurch gekennzeichnet, dass die Zelle (3) eine Gefüge aus drei hexagonalen Basismustern ist.

**Claims**

1. A semiconductor device comprising a semiconductor body (2) of a first conductivity type which is provided with a planar surface and in which an insulated gate field effect transistor is formed which is composed of a number of parallel-connected substransistors, which each comprise a polygonal box-shaped cell (3), which cells each have a first semiconductor zone (4) of the second opposite conductivity type which is provided with an edge (5) directed at right angles to the surface and extending so that a peripheral part (6) of the semiconductor body surrounding the first zone adjoins the surface, in which first zone is embedded a second zone (7) of the first conductivity type which adjoins the surface and is provided with a central opening (8) and with an edge (9) which extends at a substantially fixed distance from the edge (5) of the first zone so that a central part (10) and a narrow edge strip (11) of the first zone adjoin the surface, the pn-junction formed by the central part (10) of the first zone (4) and the second zone (7) being short-circuited by a metallization (13) applied to the surface, the edge strip (11) extending over at least part of its length at a substantially fixed distance (d) from corresponding parts of edge strips of adjacent cells, characterized in that the edge strip (11) has loops (17) enclosing strip-shaped parts (13) of the peripheral part (6) which extend in the direction of the central part (10) of the first zone (4).

2. A semiconductor device as claimed in Claim 1, characterized in that the strip-shaped parts (18) which extend in the direction of the central part (10) of the first zone (4) have a width (dl) which is substantially equally as large as the distance (d) between the edge strips of adjacent cells.

3. A semiconductor device as claimed in any one of Claims 1 and 2, characterized in that the cell (3) has the form of a hexagon.

4. A semiconductor device as claimed in any one of Claims 1 and 2, characterized in that the cell (3) has the form of a square.

5. A semiconductor device as claimed in any one of Claims 1 and 2, characterized in that the cell (3) is an assembly of three identical hexagonal basic patterns.

FIG.1

FIG.2

FIG.3

FIG.4

FIG.5